# EUROPÄISCHE PATENTSCHRIFT

(11) **EP 0 373 258 B1**
(45) Veröffentlichungstag und Bekanntmachung des Hinweises auf die Patenterteilung: **10.03.1993**
(21) Anmeldenummer: 88121168.4
(22) Anmeldetag: 16.12.1988
(51) Int. Cl.: H01L 21/90

(54) **Verfahren zur selbstjustierten Herstellung von Kontakten zwischen in übereinander angeordneten Verdrahtungsebenen einer integrierten Schaltung enthaltenen Leiterbahnen**
Method for producing self-aligned contacts between vertically separated wiring layers on an integrated circuit
Procédé de fabrication de contacts auto-alignés entre les couches conductrices en séparation verticale dans un circuit intégré

(43) Veröffentlichungstag der Anmeldung: 20.06.1990
(73) Patentinhaber: SIEMENS AKTIENGESELLSCHAFT, 80333 München (DE)
(72) Erfinder: Röska, Günther, Dr.rer.nat., D-8150 Holzkirchen (DE); Winnerl, Josef, Dr. Ing., D8300 Landshut (DE); Neppl, Franz, Dr.rer.nat., D-8000 München 90 (DE)

(56) Entgegenhaltungen:
- EP-A- 0 175 604
- US-A- 4 614 021
- PROCEEDINGS OF THE THIRD INTERNATIONAL IEEE VLSI MULTILEVEL INTERCONNECTION CONFERENCE, Santa Clara, CA, 9. - 10. Juni 1986, Seiten 450-456, IEEE; M.T. WELCH et al.: "Pillar interconnections for VLSI technology"
- PROCEEDINGS OF THE FIRST INTERNATIONAL IEEE VLSI MULTILEVEL INTERCONNECTION CONFERENCE, New Orleans, LA, 21. - 22. Juni 1984, Seiten 23-29, IEEE; R.E. OAKLEY et al.: "Pillars - The way to two micron pitch multilevel metallisation"
- S.M. SZE: "VLSI Technology", "International Student Edition", 1983, Seiten 294-296, McGRAW-HILL BOOK CO., Singapore

## Beschreibung

Die Erfindung betrifft ein Verfahren zur Herstellung von Kontakten zwischen in übereinander angeordneten Verdrahtungsebenen einen integrierten Schaltung enthaltenen Leiterbahnen.

Die Vernetzung der einzelnen Elemente oder ganzer Module einer integrierten Schaltung erfolgt bei einer Vielzahl von Familien integrierter Schaltungen durch eine Verdrahtung auf zwei oder mehr Ebenen. Zwischen diesen Ebenen liegt eine trennende Isolationsschicht. Die Ebenen sind über Kontakte durch Kontaktlöcher in der trennenden Isolationsschicht verbunden. Diese Kontakte nennt man Vias.

Die fortschreitende Miniaturisierung bei gleichzeitiger Erhöhung der Stromdichte in den metallischen Leiterbahnen von integrierten Schaltungen erfordert weitgehend mit leitendem Material gefüllte Vias.

Verschiedene Wege zur Erzeugung von Kontaktlöchern sowie zu deren Auffüllung sind aus der Literatur (s. z.B. R. H. Wilson et al J. Electrochem. Soc.: ACCELERATED BRIEF COMMUNICATION, p. 1867 (July 1987); H. P. W. Hey et al Proc. IEDM, 3.2, p.50 (1986); E. R. Sirkin, I. A. Blech, J. Electrochem. Soc., Vol. 131, No. 1, p. 123 (1983)) bekannt.

Ein Weg besteht darin, nach dem Abscheiden und Strukturieren der unteren Metallage eine Isolationsschicht aufzubringen, die zur Trennung der beiden Verdrahtungsebene dient. Diese Isolationsschicht ist im allgemeinen eine Plasmaoxidschicht, die durch spezielle Verfahren planarisierend wirkt. Die Planarisierung ist notwendig, um für die obere Metallebene die notwendige Entschärfung der Topologie zu gewährleisten. In der Isolationsschicht werden durch reaktives Ionenätzen Kontaktlöcher erzeugt. Die Auffüllung der Kontaktlöcher erfolgt beispielsweise über eine ganzflächige Wolfram-Abscheidung mit anschließendem Rückätzschritt oder durch eine selektive Wolfram-Abscheidung.

Ein solches Verfahren ist in E. Bertagnolli et al, Journal de Physique, Band 49, C 4 (1988), Seite 179 bis 182 beschrieben.

In diesem Verfahren ist nicht sicher gestellt, daß die Kontaktlöcher durch das leitende Material vollständig aufgefüllt werden, was zu einer unerwünschten Querschnittsverringerung der Leiterbahnen führen kann. Zur Erzeugung der Kontaktlöcher ist eine Maske notwendig, die relativ zu einer unteren Ebene justiert werden muß. Die Maske muß so strukturiert und justiert werden, daß ein sicherer Überlapp zwischen Leiterbahn und Kontaktloch, das heißt auch mit dem Kontakt gewährleistet ist. Dieser Überlapp stellt einen erheblichen Beitrag zur Größe des Verdrahtungsrasters in der unteren Metallebene dar und erniedrigt daher die erreichbare Packungsdichte.

Ein weiterer Weg besteht in der sogenannten Pillar-Technik, die z. B. in E. R. Sirkin, I. A. Blech, J. Electrochem. Soc., Vol. 131, No. 1, p. 123 (1983) beschrieben ist. Dabei wird das leitende Material, das später die Vias auffüllen soll, bereits vor der Isolationsschicht abgeschieden und strukturiert. Diese Strukturierung erfolgt über eine Maske, die einer komplementären Viamaske entspricht. Anschließend wird auf die Oberfläche die Isolationsschicht abgeschieden und zurückgeätzt, bis die oberen Deckflächen der erhabenen Metallbereiche freigelegt sind. Die erhabenen Metallbereiche werden als Pillar bezeichnet. Dieses Verfahren stellt eine vollständige Auffüllung der Kontaktlöcher sicher. Ferner ist sichergestellt, daß an den Kanten der Isolationsschicht eine ausreichende Schichtdicke über darunter liegenden, leitenden Schichten gegeben ist. Der Nachteil der Maskenjustierung bleibt jedoch erhalten.

Aus der europäischen Patentanmeldung EP-A-175 604 ist ein Verfahren zur Herstellung von Kontakten zwischen übereinander angeordneten Verdrahtungsebenen in der sogenannten Pillar-Technik bekannt. Dabei werden auf ein Substrat mindestens eine erste Metallschicht und eine zweite Metallschicht aufgebracht. Die erste Metallschicht und die zweite Metallschicht sind gegenseitig selektiv zueinander ätzbar. Mit Hilfe einer ersten Fotolackmaske wird die zweite Metallschicht selektiv zur ersten Metallschicht strukturiert. Dabei werden die Pillars hergestellt. Nach Entfernen der ersten Fotolackmaske wird eine zweite Fotolackmaske aufgebracht, die im wesentlichen den Verlauf der unteren Verdrahtungsebene definiert. Unter Verwendung der zweiten Fotolackmaske und der fertigen Pillars als Maske wird die erste Metallschicht in einem weiteren Ätzprozeß selektiv zu den Pillars und der zweiten Fotolackmaske geätzt. Auch bei dieser Herstellung bleibt der Nachteil der Maskenjustierung erhalten, da der Platzbedarf der Verdrahtungsebene nicht unter die Justiergenauigkeit der zweiten Fotolackmaske relativ zu den fertigen Pillars reduziert werden kann.

Ein Verfahren zur selbstjustierten Herstellung von Pillars ist aus einem Aufsatz von R. E. Oakley et al in Proceedings of the first international IEEE VLSI Multilevel Interconnection Conference, New Orleans, LA, 21. - 22. Juni, 1984, Seiten 23 - 29, IEEE bekannt. Dabei wird auf eine Halbleiteroberfläche ein Schichtaufbau bestehend aus einer ersten Metallschicht, einer zweiten Metallschicht und einer dritten Metallschicht aufgebracht. Die dritte Metallschicht ist dabei selektiv zur zweiten Metallschicht ätzbar. Mit Hilfe einer ersten Fotolackmaske, die den Verlauf der Verdrahtungsebene definiert, wird der Schichtaufbau aus erster Metallschicht, zweiter Metallschicht und dritter Metallschicht durch Ätzen strukturiert. Nach dem Entfernen der ersten Fotolackmaske wird eine zweite Fotolackmaske erzeugt, die Pillars auf der Verdrahtungsebene definiert. Durch Ätzen der dritten Metallschicht selektiv zur zweiten Metallschicht werden die Pillars hergestellt. Die Verdrahtungsebene wird aus der strukturierten ersten Metallschicht und zweiten Metallschicht gebildet. Bei der Strukturierung der Pillars mit Hilfe der zweiten Fotolackmaske wirkt der Ätzangriff auch auf der im ersten Strukturierungsschritt freigelegten Oberfläche des Halbleitersubstrats seitlich der Verdrahtungsebene. Das birgt die Gefahr von Beschädigungen der Oberfläche, die die Ausbeute reduzieren und die zu Frühausfällen führen können.

Aufgabe der vorliegenden Erfindung ist es, ein selbstjustierendes Verfahren zur Herstellung von Kontakten, sogenannten Vias, zwischen in übereinander angeordneten Verdrahtungsebenen befindlichen Leiterbahnen anzugeben, das durch den dann möglichen Verzicht auf einen Überlapp von den Vias über die Leiterbahnen der unteren Verdrahtungsebene eine Verkleinerung des Rasters der unteren Verdrahtungsebene erlaubt.

Diese Aufgabe wird erfindungsgemäß durch folgende Schritte gelöst:
a) es wird ein Schichtaufbau erzeugt, der mindestens eine erste leitende Schicht für die untere Leiterbahn und mindestens eine zweite leitende Schicht für den Kontakt enthält,
b) die Längsausdehnung des Kontaktes wird durch eine die Breite der unteren Leiterbahn sicher überlappende Maske definiert,
c) die Querausdehnung des Kontaktes wird durch die zur Erzeugung der unteren Leiterbahn notwendige Maske definiert, bevor die untere Leiterbahn mit derselben Maske definiert wird,
d) durch schrittweises Abätzen werden der Kontakt und die untere Leiterbahn erzeugt.

Da die Querausdehnung, das heißt die Ausdehnung senkrecht zum Verlauf der Leiterbahn, des Kontaktes vor der Definition der unteren Leiterbahn mit derselben Maske festgelegt wird, kann es zu einer Fehljustierung des Kontaktes zur unteren Leiterbahn nicht kommen. Daher kann auf einen Überlapp des Via mit der unteren Leiterbahn verzichtet werden. Der Kontakt entsteht in Form eines Pillars, das heißt eines erhabenen Bereichs aus leitfähigem Material, selbstjustiert zur unteren Leiterbahn. Dadurch wird eine drastische Reduzierung des unteren Verdrahtungsrasters möglich. Entsprechend wird die Packungsdichte der integrierten Schaltung erhöht. Mit diesem selbstjustierten Verfahren kann ein Flächengewinn um etwa 30 % erzielt werden.

Weitere Ausgestaltungen der Erfindung gehen aus den Unteransprüchen hervor.

Im folgenden wird die Erfindung anhand von zwei Ausführungsbeispielen und der Figuren näher erläutert.

Die Figuren 1 bis 9 stellen Verfahrensschritte zur Herstellung eines Kontaktes dar, wobei zunächst die Längsausdehnung und dann die Querausdehnung des Kontaktes definiert wird.
In Figur 10 bis Figur 13 sind Herstellschritte für einen Kontakt dargestellt, wobei zuerst die Querausdehnung und dann die Längsausdehnung definiert wird.

In allen Figuren haben gleiche Bezugszeichen die gleiche Bedeutung.

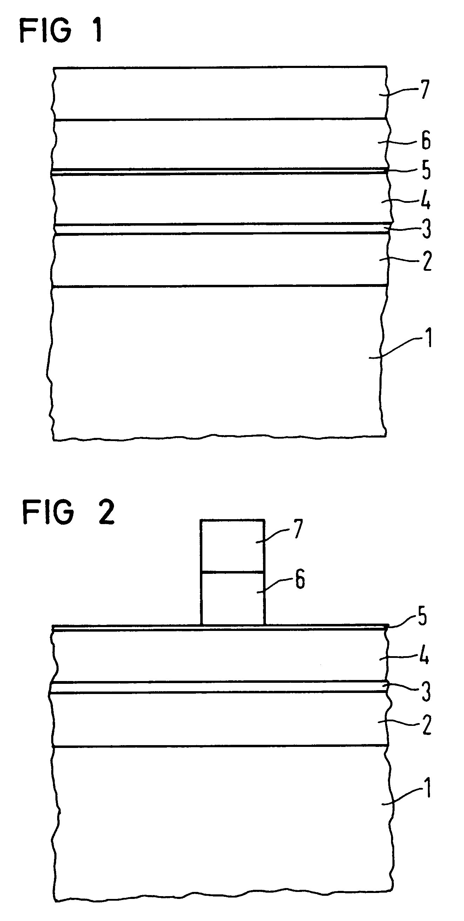

Die in Figur 1 dargestellte Struktur entsteht durch folgende Verfahrensschritte:
Auf ein Substrat 1 wird eine Isolationsschicht 2 aufgebracht. Das Substrat 1 besteht aus monokristallinem Silizium. In dem Substrat 1 sind aktive Schaltungselemente, z. B. Transistoren, enthalten. In der Isolationsschicht 2, die z. B. SiO₂ besteht, sind dort Kontaktlöcher vorgesehen, wo eine Verbindung mit den im Substrat 1 befindlichen aktiven Elementen hergestellt wird. Die aktiven Schaltungselemente und die Kontaktlöcher sind in den Figuren nicht dargestellt. Auf die Isolationssicht 2 wird eine Diffusionsbarriereschicht 3 und darauf eine erste leitende Schicht 4 abgeschieden. Aus der ersten leitenden Schicht 4 werden später die Leiterbahnen gebildet. Die erste leitende Schicht 4 wird z. B. aus Material auf Aluminiumbasis hergestellt. Sie besteht z. B. aus AlSiTi, dessen Eignung als Leiterbahnmaterial aus der europäischen Patentschrift 0110401 bekannt ist, oder z. B. aus AlSiCu, das aus I. Ames et al IBM J. Res. Develop,. vol. 14, p. 461 (1970) bekannt ist, oder aus einem auf Aluminium basierenden Mehrschichtsystem, wie es aus D. S. Gardner et al p. 114 (1984) bekannt ist. Es ist möglich, die erste leitende Schicht 4 aus einem anderen leitenden Material vorzusehen wie z. B. einem Metallsilizid oder dotiertem Polysilizium oder anderen Metallen wie z. B. Wolfram, wenn die konkrete Schaltung dieses erforderlich macht.

An der Grenzfläche zwischen Aluminium, und Monosilizium kommt es zu einer Lösung des Silizium im Aluminium und zu einer Migration des Aluminiums in das Siliziumsubstrat. Dabei werden Aluminumspikes im Substrat gebildet, die zu Substratkurzschlüssen führen können. Um diesen Effekt im Bereich von Kontaktlöchern zu vermeiden, ist zwischen der Isolationsschicht 2 und der ersten leitenden Schicht 4 die Diffusionsbarriereschicht 3 vorgesehen. Die Diffusionsbarriereschicht 3 besteht z. B. aus Ti/TiN. Auf die Diffusionsbarriereschicht 3 kann verzichtet werden, wenn dieser Effekt die Funktion von Schaltungen nicht gefährdet oder eine Metall-Monosilizium-Grenzfläche nicht vorhanden ist (z. B. weitere Metallebenen).

Auf die erste leitende Schicht 4 wird eine zweite leitende Schicht 5 abgeschieden. Die zweite leitende Schicht 5 ist wesentlich dünner als die erste leitende Schicht 4. Auf die zweite leitende Schicht 5 wird eine dritte leitende Schicht 6 abgeschieden. Die dritte leitende Schicht 6 besteht aus einem gut leitenden Material, das identisch zu dem der ersten leitenden Schicht 4 gewählt werden kann. Aus der dritten leitenden Schicht 6 werden die Kontakte in Form von Pillars gebildet. Daher muß die dritte leitende Schicht 6 in einer Dicke abgeschieden werden, die der gewünschten Höhe der Pillars entspricht. Die zweite leitende Schicht 5 besteht aus einem Material, das so auf das Material der dritten leitenden Schicht 6 abgestimmt ist, daß eine hohe Selektivität bei der Ätzung der dritten leitenden Schicht 6 gegenüber der zweiten leitenden Schicht 5 besteht. Dadurch wirkt die zweite leitende Schicht 5 bei der Ätzung der dritten leitenden Schicht 6 als Ätzstop. Auf die zweite leitende Schicht 5 wird mit Hilfe einer Fotolithographie eine erste Fotolackstruktur 7 aufgebracht.

Die erste Fotolackstruktur 7 wird so gestaltet, daß sie den Bereich, in dem später die Leiterbahn aus der ersten leitenden Schicht 4 gebildet wird, in der Breite sicher überlappt und daß in der Längsrichtung der späteren Leiterbahn die gewünschte Länge der leitenden Verbindung definiert wird. Anschließend werden die freiliegenden Teile der dritten leitenden Schicht 6 weggeätzt bis auf die zweite leitende Schicht 5, die als Ätzstop wirkt. Die sich ergebende Struktur ist in Figur 2 dargestellt.

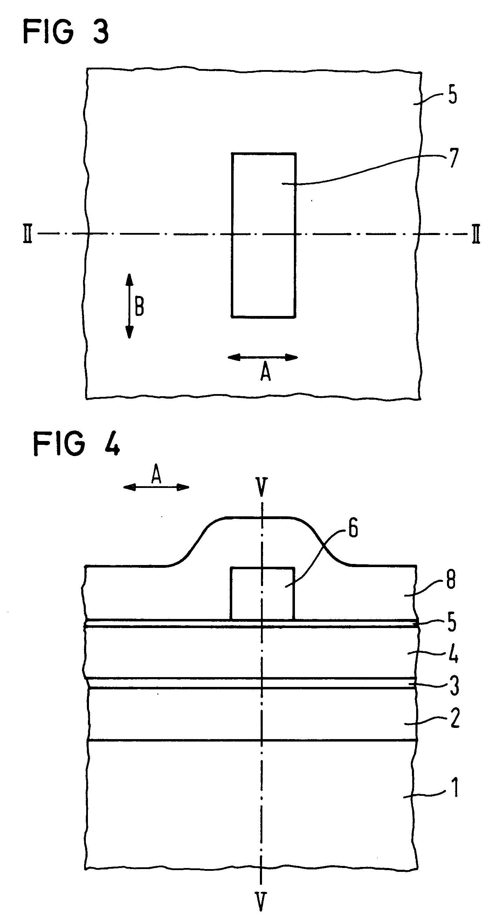

In Figur 3 ist eine Draufsicht auf die in Figur 2 dargestellte Struktur gezeigt. Außerhalb der ersten Fotolackstruktur 7 ist die dritte leitende Schicht 6 weggeätzt und die zweite leitende Schicht 5 freigelegt. Mit II-II ist der in Figur 2 dargestellte Schnitt bezeichnet. Mit dem Doppelpfeil A ist die Richtung parallel zur Längsrichtung der späteren Leiterbahn und mit dem Doppelpfeil B die Richtung senkrecht zur Längsrichtung der späteren Leiterbahn angedeutet.

Wie in Figur 4 dargestellt wird die Struktur nach dem Entfernen der ersten Fotolackstruktur 7 mit einer zweiten Fotolackstruktur 8 versehen. Die zweite Fotolackstruktur 8 ist so gestaltet, daß sie zur Strukturierung der Leiterbahn geeignet ist, die aus der ersten leitenden Schicht 4 im weiteren gebildet wird.

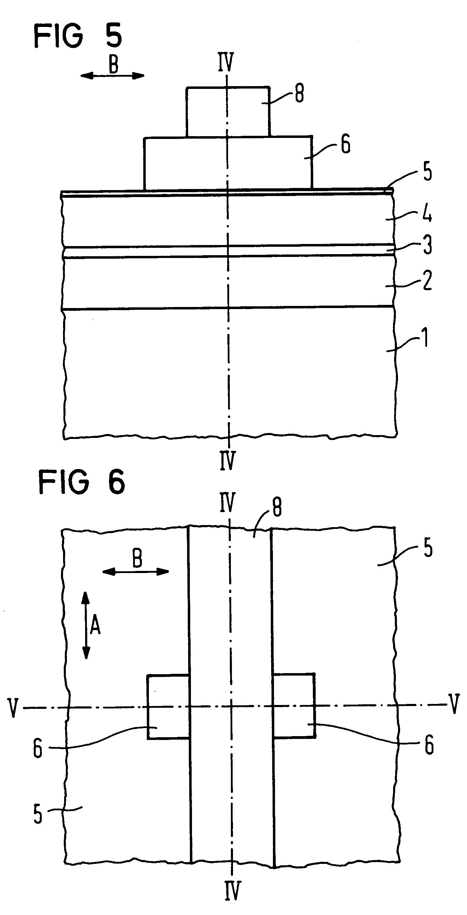

In Figur 5 ist der in Figur 4 mit V-V bezeichnete Schnitt dargestellt. Es zeigt sich, daß die zweite Fotolackstruktur 8 in dieser Ansicht schmaler ist als die dritte leitende Schicht 6. Die dritte leitende Schicht 6 war im ersten Ätzschritt so strukturiert worden, daß sie die später zu bildende Leiterbahn in der Breite sicher überlappt. Mit IV-IV ist der in Figur 4 dargestellte Schnitt bezeichnet.

In Figur 6 ist die Draufsicht dieser Struktur dargestellt. Die zweite Fotolackstruktur 8, die die Struktur der späteren Leiterbahn hat, verläuft über die dritte leitende Schicht 6. In der Breite ragt die dritte leitende Schicht 6 über die zweite Fotolackstruktur 8 deutlich heraus. Die Länge der dritten leitenden Schicht 6 ist durch den vorherigen Ätzschritt festgelegt. Mit IV-IV ist der in Figur 4 und mit V-V der in Figur 5 dargestellten Schnitt bezeichnet.

Der Lithographieschritt zur Strukturierung der zweiten Fotolackstruktur 8 in Form der späteren Leiterbahn muß den Höhenunterschied im Bereich der dritten leitenden Schicht 6 (s. Figur 4) bewältigen können. Je nach Dicke der dritten leitenden Schicht 6, das heißt nach gewünschter Höhe des Pillars, können hier Probleme bei der Belichtung (Schärfentiefe) und bei der Lacktechnik auftreten. Diese Probleme können durch Ausweichen von der konventionellen Einschichtlacktechnik auf eine Mehrschichtlacktechnik umgangen werden.

Im nächsten Schritt werden diejenigen Bereiche der dritten leitenden Schicht 6 weggeätzt, die von der ersten Fotolackstruktur 7 geschützt waren und die von der zweiten Fotolackstruktur 8 unbedeckt sind (vergleiche Figur 5 und Figur 6). Dadurch wird die dritte leitende Schicht 6 auch in der Richtung quer (angedeutet durch den Doppelpfeil B) zur zweiten Fotolackstruktur 8 definiert. Die Ätzung der dritten leitenden Schicht 6 erfolgt wiederum bis auf die zweite leitende Schicht 5, die als Ätzstop wirkt. Der von der zweiten Fotolackstruktur 8 unbedeckte Teil der Oberfläche wird von der zweiten leitenden Schicht 5 bei der Ätzung geschützt. Nach diesem Schritt sind die Pillars vollständig hergestellt.

Anschließend wird die Leiterbahn strukturiert, wobei die zweite Fotolackstruktur 8 als Maske wirkt. Dazu muß zunächst die zweite leitende Schicht 5 abgeätzt werden. Dann wird die erste Schicht 4 abgeätzt. Es ist vorteilhaft, das Material der ersten Schicht 4 so auf das Material der darunterliegenden Diffusionsbarriereschicht 3 abzustimmen, daß die Diffussionsbarriereschicht 3 einen Ätzstop bei der Ätzung der ersten leitenden Schicht 4 bildet, da diese Ätzung stark überzogen werden muß. Durch ein Überziehen der Ätzung der ersten leitenden Schicht 4 werden eventuell vorhandene Metallreste insbesondere zwischen zwei Pillars eliminiert, die wegen des erhöhten Aspektverhältnisses befürchtet werden müssen. Anschließend wird die Diffusionsbarriereschicht 3 weggeätzt bis auf die Isolationsschicht 2.

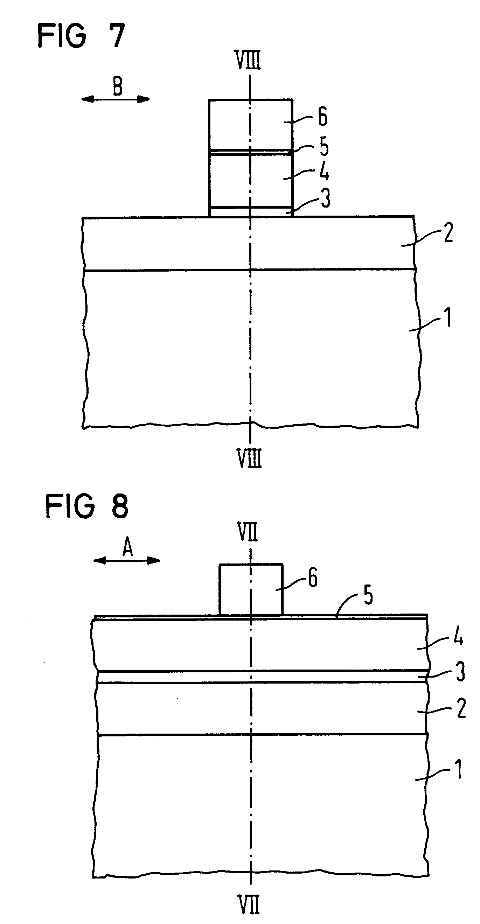

In Figur 7 ist die sich ergebende Struktur nach Entfernung der zweiten Fotolackstruktur 8 dargestellt. In Figur 8 ist der mit VIII-VIII bezeichnete Schnitt in Figur 7 dargestellt. In Figur 7 zeigt sich, daß die dritte leitende Schicht 6 selbstjustiert über der ersten leitenden Schicht 4 angeordnet ist. Die Breite des aus der dritten leitenden Schicht 6 gebildeten Pillars ist herstellungsgemäß gleich derjenigen der aus der ersten leitenden Schicht 4 gebildeten Leiterbahn. In Figur 8 mit VII-VII der in Figur 7 dargestellte Schnitt bezeichnet.

In der in Figur 8 dargestellten Ansicht zeigt sich, daß der aus der dritten leitenden Schicht 6 gebildete Pillar in der Längsrichtung (Doppelpfeil A) der aus der ersten leitenden Schicht 4 gebildeten Leiterbahn begrenzt ist. Die Oberfläche der aus der ersten leitenden Schicht 4 gebildeten Leiterbahn bleibt mit der zweiten leitenden Schicht 5 bedeckt. Die erste leitende Schicht 4 schützt beim Tempern die freiliegende Oberfläche der aus der ersten leitenden Schicht 4 gebildeten Leiterbahn vor der sogenannten vertikalen Hillockbildung. Unter Hillocks versteht man Materialansammlungen auf den metallisierten Bereichen (vertikale Hillocks) oder an den geätzten Seitenwänden (laterale Hillocks). Hillocks können bei Temperprozessen, aber auch bei Strombelastungen entstehen. Die zweite leitende Schicht 5 wirkt daher als Schutz gegen vertikales Hillockwachstum auf der aus der ersten leitenden Schicht 4 gebildeten Leiterbahn. Dagegen kann eine solche bedeckende Schicht das laterale Hillockwachstum fördern.

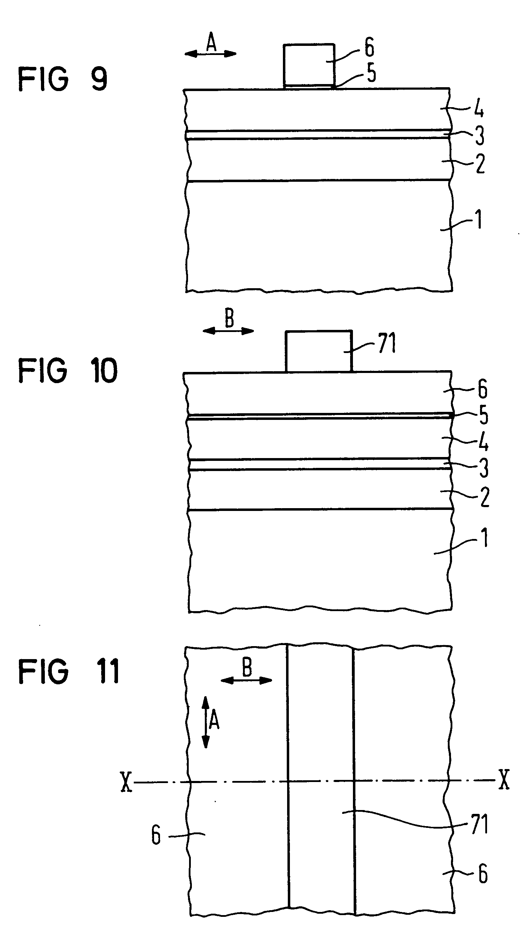

Neigt die aus der ersten leitenden Schicht 4 gebildete Leiterbahn durch das verwendete Material oder die Prozeßführung zu lateraler Hillockbildung, muß die zweite leitende Schicht 5 außerhalb der aus der dritten leitenden Schicht 6 gebildeten Pillars entfernt werden. Dies kann z. B. vor dem Entfernen der zweiten Fotolackstruktur 8 erfolgen. In Figur 9 ist die sich dann ergebende Struktur dargestellt.

Für den Fall, daß die Diffusionsbarriereschicht 3 und die zweite leitende Schicht 5 in dem selben Prozeß ätzbar sind, wird noch vor der Strukturierung der Diffusionsbarriereschicht 3 die zweite Fotolackstruktur 8 entfernt. Dann wird in einem einzigen ganzflächigen Ätzschritt der oberste Teil der dritten leitenden Schicht 6, die freiliegende zweiten leitende Schicht 5 sowie die freiliegende Diffusionsbarriereschicht 3 abgeätzt. Sollte keine Diffusionsbarriereschicht 3 vorgesehen sein, sollte ein Ätzverfahren angewendet werden, das eine hohe Selektivität gegenüber der darunter liegenden Isolationsschicht 2 aufweist.

Anhand der Figuren 10 bis 13 wird im folgenden ein weiteres, aus dem aufsatz von R.E. Oakley et al. bekanntes Ausführungsbeispiel beschrieben.

In Figur 10 ist der Schichtaufbau dargestellt mit dem Substrat 1, der Isolationsschicht 2, der Diffusionsbarriereschicht 3, der ersten leitenden Schicht 4, der zweiten leitenden Schicht 5 und der dritten leitenden Schicht 6, dessen Herstellung im Zusammenhang mit Figur 1 beschrieben wurde. Auf der dritten leitenden Schicht 6 wird eine erste Fotolackmaske 71 erzeugt.

In Figur 11 ist eine Draufsicht der Struktur aus Figur 10 dargestellt. Mit X-X ist der in Figur 10 dargestellte Schnitt bezeichnet. Es zeigt sich, daß die erste Fotolackmaske 71 so strukturiert ist, daß sie den Verlauf einer Leiterbahn, die später aus der ersten leitenden Schicht 4 gebildet wird, definiert. Es werden nacheinander die dritte leitende Schicht 6, die zweite leitende Schicht 5, die erste leitende Schicht 4 und, falls vorhanden, die Diffusionsbarriereschicht 3 entsprechend der ersten Fotolackmaske 71 abgeätzt. Dadurch wird aus der ersten leitenden Schicht 4 die Leiterbahn gebildet. Die zweite leitende Schicht 5, aus der der Pillar gebildet wird, erhält in diesem Ätzschritt herstellungsgemäß dieselbe Breite wie die aus der ersten leitenden Schicht 4 gebildete Leiterbahn. Die zweite leitende Schicht 5 ist selbstjustiert über der aus der ersten leitenden Schicht 4 gebildeten Leiterbahn angeordnet.

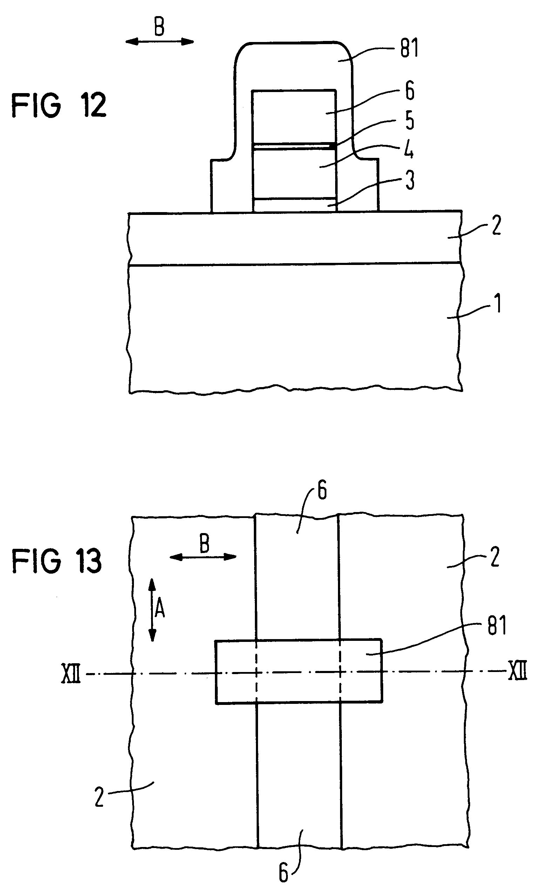

In Figur 12 ist die sich ergebende Struktur nach dem Entfernen der ersten Fotolackmaske 71 und nach dem Aufbringen einer zweiten Fotolackmaske 81 dargestellt. Die zweite Fotolackmaske 81 überlappt die entsprechend der Leiterbahn strukturierten Diffusionsbarriereschicht 3, erste leitende Schicht 4, zweite leitende Schicht 5 und dritte leitende Schicht 6 in der Breite sicher. Bei dem Lithographieschritt zur Erzeugung der zweiten Fotolackmaske 81 sind die im Zusammenhang mit Figur 5 erläuterten Schärfentiefe Probleme nicht relevant, da bei dieser Prozeßführung lediglich die dritte leitende Schicht 6 strukturiert werden muß. Hierin liegt der Hauptunterschied zwischen den zwei Ausführungsformen.

In Figur 13 ist eine Draufsicht auf die Struktur aus Figur 12 dargestellt. Mit X-X ist der in Figur 12 dargestellte Schnitt bezeichnet. Es zeigt sich, daß die zweite Fotolackmaske 81 die entsprechend der Leiterbahn strukturierte dritte leitende Schicht 6 in der Breite sicher überlappt. In der Länge definiert die zweite Fotolackmaske 81 die Ausdehnung des zu erzeugenden Pillars. Im nächsten Schritt werden die frei liegenden Bereiche der dritten leitenden Schicht 6 abgeätzt bis auf die erste leitende Schicht 4, die wiederum als Ätzstop wirkt. Der aus der dritten leitenden Schicht 6 gebildete Pillar ist selbstjustiert oberhalb der aus der ersten leitenden Schicht 4 gebildeten Leiterbahn angeordnet und mit dieser über die zweite leitende Schicht 5 leitend verbunden.

Je nach dem, ob die zweite leitende Schicht 5 als Deckschicht zum Schutz gegen vertikale Hillockbildung erwünscht ist oder nicht, wird die zweite Fotolackmaske 81 sofort entfernt, wobei sich die in Figur 8 dargestellte Struktur ergibt, oder werden die freiliegenden Bereiche der zweiten leitenden Schicht 5 bis auf die erste leitende Schicht 4 abgeätzt, und es wird dann die Fotolackmaske 81 entfernt, wobei sich die in Figur 9 dargestellte Struktur ergibt.

In bekannter Weise (s. z. B. E. R. Sirkin, I. A. Blech, J. Electrochem. Soc., Vol. 131, No. 1, p. 123 (1983)) wird die Oberfläche mit einer Isolationsschicht (nicht dargestellt) versehen, die oberhalb des Pillars bis auf den Pillar abgeätzt wird.

Beide Ausführungsformen des erfindungsgemäßen Verfahrens enthalten selbstjustierte, vollständig gefüllte Kontaktlöcher, wobei als Option auf eine Hillock hemmende Deckschicht zurückgegriffen werden kann. Für beide Ausführungsformen kann der gleiche Maskensatz (in unterschiedlicher Reihenfolge) verwendet werden. Das Raster der unteren Verdrahtungsebene wird um den Überlapp zwischen Leiterbahn und Via verringert.

Die beiden Ausführungsvarianten unterscheiden sich in ihren Anforderungen an die Fotolithographie, die Lack- sowie die Ätztechnik. Je nach Anwendungsfall erweist sich eines der beiden Verfahren als vorteilhafter. Die zuerst beschriebene Variante eignet sich besser für wenig tiefe Vias und dickere Leiterbahnen, wogegen die zuletzt beschriebene Variante besonders für Vias geeignet ist, die einen großen Höhenunterschied bewältigen müssen.

## Patentansprüche

1. Verfahren zur Herstellung von Kontakten zwischen in übereinander angeordneten Verdrahtungsebenen einer integrierten Schaltung enthaltenen Leiterbahnen mit folgenden Schritten:
a) auf ein mit einer Isolationsschicht (2) versehenes monokristallines Siliziumsubstrat (1) wird die erste leitende Schicht (4) für die untere Verdrahtungsebene aufgebracht,
b) auf die erste leitende Schicht (4) wird eine zweite leitende Schicht (5), die dünner als die erste leitende Schicht (4) ist, abgeschieden,
c) auf die zweite leitende Schicht (5) wird eine dritte leitende Schicht (6) in der gewünschten Dicke des Kontaktes abgeschieden, wobei das Material der zweiten leitenden Schicht (5) so auf das Material der dritten leitenden Schicht (6) abgestimmt ist, daß die zweite leitende Schicht (5) bei der Ätzung der dritten leitenden Schicht (6) als Ätzstop wirkt,
d) auf die dritte leitende Schicht (6) wird eine erste Fotolackschicht (7) aufgebracht und so strukturiert, daß die Struktur in der Breite die später in der ersten leitenden Schicht (4) zu bildende Leiterbahn sicher überlappt und daß die Struktur in der Längsrichtung die gewünschte Länge des Kontaktes definiert,
e) die freiliegenden Teile der dritten leitenden Schicht (6) werden bis auf die zweite leitende Schicht (5) abgeätzt,
f) nach Entfernen der Strukturen der ersten Fotolackschicht (7) wird eine zweite Fotolackschicht (8) aufgebracht,
g) die zweite Fotolackschicht (8) wird in einem Fotolithografieschritt so strukturiert, daß die untere Leiterbahn durch die strukturierte, zweite Fotolackschicht (8) definiert wird,
h) die freiliegenden Teile der dritten leitenden Schicht (6) werden bis auf die zweite leitende Schicht (5) abgeätzt,
i) die freiliegenden Teile der zweiten leitenden Schicht (5) werden bis auf die erste leitende Schicht (4) abgeätzt,
j) die untere Leiterbahn wird durch Abätzen der freiliegenden Teile der ersten leitenden Schicht (4) erzeugt,
k) die Reste der zweiten Fotolackschicht (8) werden entfernt.

2. Verfahren nach Anspruch 1, dadurch **gekennzeichnet,** daß vor dem Aufbringen der ersten leitenden Schicht (4) eine leitfähige Diffusionsbarriereschicht (3) auf die Isolationsschicht (2) aufgebracht wird und daß vor dem Entfernen der zweiten Fotolackschicht (8) die freiliegenden Bereiche der Diffusionsbarriereschicht (3) bis auf die Isolationsschicht (2) abgeätzt werden.

3. Verfahren nach Anspruch 1 oder 2, dadurch **gekennzeichnet,** daß als zweite Fotolackschicht (8) eine aus mehreren Schichten zusammengesetzte Schicht verwendet wird.

4. Verfahren nach einem der Ansprüche 1 bis 3, dadurch **gekennzeichnet,** daß die zweite leitende Schicht (5) auf der unteren Leiterbahn außerhalb des Kontaktes abgeätzt wird.

5. Verfahren nach einem der Ansprüche 1 bis 3, dadurch **gekennzeichnet,** daß vor dem Entfernen der Strukturen der ersten Fotolackschicht (7) in Schritt f die freiliegenden Bereiche der zweiten leitenden Schicht (5) bis auf die erste leitende Schicht (4) abgeätzt werden.

## Claims

1. Method for the production of contacts between conductor tracks contained in wiring layers that are arranged one above the other, of an integrated circuit, with the following steps:
a) the first conductive layer (4) for the lower wiring layer is applied onto a monocrystalline silicone substrate (1) which is provided with an insulation layer (2),
b) a second conductive layer (5), which is thinner than the first conductive layer (4), is deposited onto the first conductive layer (4),
c) a third conductive layer (6) is deposited in the desired thickness of the contact onto the second conductive layer (5), the material of the second conductive layer (5) being matched to the material of the third conductive layer (6) such that the second conductive layer (5) acts as an etching stop during etching of the third conductive layer (6),
d) a first photoresist layer (7) is applied onto the third conductive layer (6) and is structured such that the structure overlaps in width the conductor track which is to be formed later in the first conductive layer (4), and such that the structure defines the desired length of the contact in the longitudinal direction,
e) the exposed parts of the third conductive layer (6) are etched away as far as the second conductive layer (5),
f) a second photoresist layer (8) is applied after removal of the structures of the first photoresist layer (7),
g) the second photoresist layer (8) is structured in a photo-lithographic step such that the lower conductor track is defined by the structured, second photoresist layer (8),
h) the exposed parts of the third conductive layer (6) are etched away as far as the second conductive layer (5),
i) the exposed parts of the second conductive layer (5) are etched away as far as the first conductive layer (4),
j) the lower conductor track is produced by etching away the exposed parts of the first conductive layer (4),
k) the remainder of the second photoresist layer (8) is removed.

2. Method according to Claim 1, characterised in that a conductive diffusion-barrier layer (3) is applied onto the insulation layer (2) before the application of the first conductive layer (4), and in that the exposed regions of the diffusion-barrier layer (3) are etched away as far as the insulation layer (2) before the removal of the second photoresist layer (8).

3. Method according to Claim 1 or 2, characterised in that a layer composed of a plurality of layers is used as the second photoresist layer (8).

4. Method according to one of Claims 1 to 3, characterised in that the second conductive layer (5) is etched away on the lower conductor track outside the contact.

5. Method according to one of Claims 1 to 3, characterised in that, in step f, the exposed regions of the second conductive layer (5) are etched away as far as the first conductive layer (4) before the removal of the structures of the first photoresist layer (7).

## Revendications

1. Procédé pour établir des contacts entre des voies conductrices disposées dans des plans superposés de câblage d'un circuit intégré, comportant les étapes suivantes:
a) sur un substrat en silicium monocristallin (1) p ourvu d'une couche isolante (2), on dépose une première couche conductrice (4) pour le plan inférieur de câblage,
b) sur la première couche conductrice (4), on dépose une seconde couche conductrice (5), qui est plus mince que la première couche conductrice (4),
c) sur la seconde couche conductrice (5), on dépose une troisième couche conductrice (6) possédant l'épaisseur désirée du contact, le matériau de la seconde couche conductrice (5) étant adapté au matériau de la troisième couche conductrice (6) de sorte que la seconde couche conductrice (5) agit en tant que dispositif d'arrêt de corrosion lors de la corrosion de la troisième couche conductrice (6),
d) sur la troisième couche conductrice (6), on dépose une première couche de vernis photosensible (7) et on la structure de manière que la structure chevauche de façon sûre, dans le sens de la largeur, la voie conductrice devant être formée ultérieurement dans la première couche conductrice (4), et que la structure définisse, dans la direction longitudinale, la longueur désirée du contact,
e) on élimine par corrosion les parties à nu de la troisième couche conductrice (6) hormis ou niveau de la seconde couche conductrice (5),
f) après élimination des structures de la première couche de vernis photosensible (7), on dépose une seconde couche de vernis photosensible (8),
g) on structure la seconde couche de vernis photosensible (8) lors d'une étape de photolithographie, de manière que la bande conductrice inférieure soit définie par la seconde couche de vernis photosensible structurée (8),
h) on élimine par corrosion les parties à nu de la troisième couche conductrice (6), hormis au niveau de la seconde couche conductrice (5),
i) on élimine par corrosion les parties à nu de la seconde couche conductrice (5), hormis au niveau de la première couche conductrice (4),
j) on forme la voie conductrice inférieure en éliminant par corrosion les parties à nu de la première couche conductrice (4),
k) on élimine les restes de la seconde couche de vernis photosensible (8).

2. Procédé suivant la revendication 1, caractérisé par le fait qu'avant le dépôt de la première couche conductrice (4), on dépose une couche conductrice (3) formant barrière contre la diffusion, sur la couche isolante (2) et qu'avant l'élimination de la seconde couche de vernis photosensible (8) on élimine par corrosion les zones à nu de la couche (3) formant barrière contre la diffusion, hormis au niveau de la couche isolante (2).

3. Procédé suivant la revendication 1 ou 2, caractérisé par le fait qu'on utilise comme seconde couche de vernis photosensible (8), une couche formée par la réunion de plusieurs couches.

4. Procédé suivant l'une des revendications 1 à 3, caractérisé par le fait qu'on élimine par corrosion la seconde couche conductrice (5) sur la voie conductrice inférieure à l'extérieur du contact.

5. Procédé suivant l'une des revendications 1 à 3, caractérisé par le fait qu'avant l'élimination des structures de la première couche de vernis photosensible (7) lors de l'étape f), on élimine par corrosion les zones à nu de la seconde couche conductrice (5) hormis au niveau de la première couche conductrice (4).
